# EUROPEAN PATENT APPLICATION

(11) **EP 4 618 412 A1**
(43) Date of publication of application: **17.09.2025**
(21) Application number: 25160271.0
(22) Date of filing: 26.02.2025
(51) Int. Cl.: H03F 3/60, H03F 1/02, H03F 1/32, H03F 3/195, H03F 3/24

(54) **MULTI-STAGE LOAD MODULATED BALANCED AMPLIFIER**

(30) Priority: 15.03.2024 US 202463566095 P; 20.06.2024 US 202418749388; 20.06.2024 US 202418749395
(71) Applicant: Analog Devices International Unlimited Company, Limerick (IE)
(72) Inventor: THOMPSON, William Henry, Co. Limerick (IE); COPE, Mark, Co. Limerick (IE); OUTALEB, Noureddine, Co. Limerick (IE); BEN ARFI, Anis, Co. Limerick (IE)
(74) Representative: Yang, Shu

(57) **Abstract**

Aspects of this disclosure relate to a multi-stage pseudo-Doherty load modulated balanced amplifier (10) that includes a control stage (12) and balanced stages (14, 16). The balanced stages (14, 16, 23, 25) can each include a balanced amplifier (14, 16) biased in class C. The balanced stages (14, 16, 23, 25) can each include an output coupler (23, 25) having a port driven by another stage of the multi-stage pseudo-Doherty load modulated balanced amplifier (10). In certain embodiments, two or more stages of the multi-stage pseudo-Doherty load modulated balanced amplifier (10) are driven by separate drive signals.

## Description

### CROSS REFERENCE TO PRIORITY APPLICATIONS

This application claims the benefit of priority of U.S. Provisional Application No. 63/566,095, filed March 15, 2024, and titled "MULTI-DRIVE PSEUDO-DOHERTY LOAD MODULATED BALANCED AMPLIFIER AND DRIVE SIGNAL EXTRACTION METHOD," U.S. Application No. 18/749,388, filed June 20, 2024, and titled "MULTI-STAGE LOAD MODULATED BALANCED AMPLIFIER," and U.S. Application No. 18/749,395, filed June 20, 2024, and titled "TRANSCEIVER FOR DRIVING LOAD MODULATED BALANCED AMPLIFIER."

### BACKGROUND

### TECHNICAL FIELD

The disclosed technology relates to amplifiers and methods for determining drive signals for amplifiers. Embodiments of the disclosure relate to multi-drive pseudo-Doherty load modulated balanced amplifiers and drive signal extraction methods.

### DESCRIPTION OF RELATED TECHNOLOGY

Radio systems can transmit and receive signals in the form of electromagnetic waves having a frequency in range from approximately 30 kilohertz (kHz) to 300 Gigahertz (GHz). Radio systems can be used for wireless communications, such as cellular communications and/or other wireless network communications.

Radio systems that transmit signals often include a power amplifier to amplify a radio frequency signal for transmission via one or more antennas. Power amplifiers can encounter technical challenges related to efficiency, output power, and/or linearity. High performance power amplifiers are desired.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a multi-stage pseudo-Doherty load modulated balanced amplifier circuit that includes a control stage, a first balanced stage, and a second balanced stage. The control stage includes a control amplifier. The first balanced stage includes a first balanced amplifier and a first output coupler. The first balanced amplifier is coupled to the first output coupler and is configured to be biased in class C. The first output coupler has a port connected to an output of the control amplifier. The second balanced stage includes a second balanced amplifier and a second output coupler. The second balanced amplifier is coupled to the second output coupler and is configured to be biased in class C. The second output coupler has a port connected to an output of the first balanced stage.

The first balanced stage and the second balanced stage can be configured to receive separate drive signals. The multi-stage pseudo-Doherty load modulated balanced amplifier circuit can include a digital splitter configured to provide the separate drive signals. The digital splitter can implement non-linear frequency selective functions. The multi-stage pseudo-Doherty load modulated balanced amplifier circuit can include a controller configured to update the digital splitter.

The port of the second output coupler connected to the output of the first balanced stage can be an isolation port.

The multi-stage pseudo-Doherty load modulated balanced amplifier circuit can include a first current sensor and a second current sensor. The first current sensor can provide an indication of direct current input power of the first balanced stage. The second current sensor can provide an indication of direct current input power of the second balanced stage. The multi-stage pseudo-Doherty load modulated balanced amplifier circuit can include a radio frequency coupler and a controller. The radio frequency coupler can be connected to a radio frequency output port of the second output coupler, the radio frequency coupler can be coupled to the controller, and the controller can be coupled to the first current sensor and the second current sensor. The multi-stage pseudo-Doherty load modulated balanced amplifier circuit can include a third current sensor coupled to the controller. The third current sensor can provide an indication of direct current input power of the control stage.

The multi-stage pseudo-Doherty load modulated balanced amplifier circuit can include one or more additional balanced stages each comprising an additional balanced amplifier configured to be biased in class C and an additional output coupler. The additional output coupler of each of the one or more additional balanced stages can have a port driven by another stage of the multi-stage pseudo-Doherty load modulated balanced amplifier circuit.

The multi-stage pseudo-Doherty load modulated balanced amplifier circuit can include a radio frequency power divider coupled to two stages of the pseudo-Doherty load modulated balanced amplifier circuit. The radio frequency power divider can divide power of a combined drive signal to the two stages of the pseudo-Doherty load modulated balanced amplifier circuit.

The multi-stage load modulated balanced amplifier circuit can be operable in a plurality of power modes. The plurality of power modes can include a high power mode where the control amplifier modulates the first balanced amplifier from peak efficiency to peak output power. The plurality of power modes can include a high power mode where separate drive signals for the control stage and the first balanced stage change power and phase.

Another aspect of this disclosure is a method of signal amplification with a multi-stage pseudo-Doherty load modulated balanced amplifier circuit. The method includes biasing a first balanced amplifier and a second balanced amplifier of the multi stage pseudo-Doherty load modulated balanced amplifier circuit in class C; providing separate drive signals to the first balanced amplifier, the second balanced amplifier, and a control amplifier of the multi-stage pseudo-Doherty load modulated balanced amplifier circuit; and providing, by the multi-stage pseudo-Doherty load modulated balanced amplifier circuit, an amplified radio frequency output signal. The first balanced amplifier is coupled to a first output coupler that has an isolation port connected to an output of the control amplifier, and the second balanced amplifier is coupled to a second output coupler that has an isolation port connected to a radio frequency output port the of first output coupler.

The method can include generating the separate drive signals using a digital splitter. The method can include updating the digital splitter based on outputs of currents sensors associated with the first balanced amplifier, the second balanced amplifier, and the control amplifier. The updating the digital splitter can be based on the amplified radio frequency output signal.

The multi-stage load modulated balanced amplifier circuit can include one or more additional balanced amplifiers.

Another aspect of this disclosure is a multi-stage pseudo-Doherty load modulated balanced amplifier circuit comprising that includes a control stage, a first balanced stage, and a second balanced stage. The control stage includes a control amplifier. The first balanced stage includes a first balanced amplifier, a first current sensor configured to provide an indication of direct current input power of the first balanced stage, and a first output coupler. The first balanced amplifier is coupled to the first output coupler and configured to be biased in class C. The first output coupler has an isolation port connected to an output of the control amplifier. The second balanced stage includes a second balanced amplifier, a second current sensor configured to provide an indication of direct current input power of the second balanced stage, and a second output coupler. The second balanced amplifier is coupled to the second output coupler and configured to be biased in class C. The second output coupler has an isolation port connected to an output of the first balanced stage. The first balanced stage and the second balanced stage are configured to receive separate drive signals.

Another aspect of this disclosure is a transceiver for driving a pseudo-Doherty load modulated balanced amplifier. The transceiver includes a digital splitter and a controller. The digital splitter is configured to provide drive signals to the pseudo-Doherty load modulated balanced amplifier. The controller configured to generate a measure of efficiency of the pseudo-Doherty load modulated balanced amplifier based on an observed radio frequency output power of the pseudo-Doherty load modulated balanced amplifier and an output signal from a current sensor associated with the pseudo-Doherty load modulated balanced amplifier. The controller can configure the digital splitter based on the measure of efficiency of the pseudo-Doherty load modulated balanced amplifier.

The digital splitter can include frequency selective non-linear filters. The digital splitter can further include a frequency selective linear filter cascaded with a frequency selective non-linear filter of the frequency selective non-linear filters.

The controller can generate measures of efficiency of the pseudo-Doherty load modulated balanced amplifier for a plurality of configurations, and configure the digital splitter based on the measures of efficiency of the pseudo-Doherty load modulated balanced amplifier for the plurality of configurations.

The controller can generate measures of efficiency of the pseudo-Doherty load modulated balanced amplifier for a plurality of power regions, and configure the digital splitter based on the measures of efficiency of the pseudo-Doherty load modulated balanced amplifier for the plurality of power regions. The plurality of power regions can include a power region in which (i) power and phase of the drive signals change and (ii) a control amplifier is used to modulate a load of the balanced amplifier of the pseudo-Doherty load modulated balanced amplifier from peak efficiency to peak power.

The controller can estimate the efficiency for test sections of the load modulated balanced amplifier starting with a test section associated with a lowest power of the plurality of test sections. Each of the test sections can be divided into a balanced stage and a control stage, wherein the control stage of at least one of the test sections includes a balanced amplifier and a control amplifier.

The controller can estimate the efficiency of the pseudo-Doherty load modulated balanced amplifier based on an output signal from a second current sensor associated with the pseudo-Doherty load modulated balanced amplifier. The current sensor and the second current sensor can be associated with different stages of the pseudo-Doherty load modulated balanced amplifier.

The controller can adaptively update the digital splitter.

The transceiver can include a digital predistortion system having an output connected to an input of the digital splitter.

Another aspect of this disclosure is a method of drive signal extraction for driving a pseudo-Doherty load modulated balanced amplifier. The method includes generating test signal for the pseudo-Doherty load modulated balanced amplifier; receiving an observed radio frequency output power of the pseudo-Doherty load modulated balanced amplifier associated with the test signal; determining efficiency of the pseudo-Doherty load modulated balanced amplifier based on the observed radio frequency output power; and configuring a digital splitter based on the determining, wherein the digital splitter provides drive signals for stages of the pseudo-Doherty load modulated balanced amplifier.

Determining efficiency can include determining efficiency for a plurality of power regions. The plurality of power regions can include a power region where power and phase of the drive signals change. The plurality of power regions can include a power region where a control amplifier is used to modulate a balanced amplifier of pseudo-Doherty the load modulated balanced amplifier from peak efficiency to peak power.

Determining efficiency can be based on output signals from current sensors associated with component amplifiers of the pseudo-Doherty load modulated balanced amplifier.

The pseudo-Doherty load modulated balanced amplifier can be a multi-stage pseudo-Doherty load modulated balanced amplifier having three or more stages, and wherein the generating, the receiving, and the determining are performed for each stage of a multi-stage load modulated balanced amplifier. The multi-stage pseudo-Doherty load modulated balanced amplifier can include a control amplifier, a first balanced amplifier, a first output coupler configured to combine output signals of the first balanced amplifier and having an isolation port connected to an output of the control amplifier, a second balanced amplifier, and a second output coupler configured to combine output signals of the second balanced amplifier and having an isolation port connected to a port of the first output coupler.

Generating, the receiving, and the determining can be performed for test sections of the pseudo-Doherty load modulated balanced amplifier starting with a section associated with a lowest power of the test sections. Each of the test sections can be divided into a balanced stage and a control stage. The control stage of at least one of the test sections can include a balanced amplifier and a control amplifier.

Another aspect of this disclosure is a system that includes a digital splitter, a pseudo-Doherty load modulated balanced amplifier, and a controller. The digital splitter is configured to split a combined drive signal into at least a first drive signal and a second drive signal. The pseudo-Doherty load modulated balanced amplifier includes a control amplifier configured to amplify the first drive signal, an input coupler configured to receive the second drive signal, and a balanced amplifier having inputs connected to the input coupler. The controller is configured to determine a measure of efficiency of the pseudo-Doherty load modulated balanced amplifier based on an observed radio frequency output power of the pseudo-Doherty load modulated balanced amplifier and an output signal from a current sensor associated with the pseudo-Doherty load modulated balanced amplifier. The controller is configured to configure the digital splitter based on the measure of efficiency of the pseudo-Doherty load modulated balanced amplifier.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

### BRIEF DESCRIPTION OF THE DRAWINGS

Embodiments of this disclosure will be described, by way of non-limiting example, with reference to the accompanying drawings.
Figure 1 is a schematic diagram of a multi-stage pseudo-Doherty load modulated balanced amplifier (LMBA) according to an embodiment.
Figure 2 is a schematic diagram of a three stage LMBA according to an embodiment.
Figure 3 is a graph of drain efficiency versus output power for the three stage LMBA of Figure 2.
Figure 4 is a schematic diagram of a two stage LMBA circuit with current sensors according to an embodiment.
Figures 5A, 5B, and 5C are graphs associate with estimating efficiency of the LMBA of Figure 4.
Figure 6 is a schematic block diagram of a transceiver with a controller and a digital splitter according to an embodiment.
Figure 7 is a schematic block diagram of a single stage digital splitter according to an embodiment.
Figure 8 is a schematic block diagram of a multi-stage digital splitter according to an embodiment.
Figure 9 is a flow diagram of a method for drive signal extraction for a multi-stage LMBA according to an embodiment.
Figures 10A, 10B, and 10C are schematic diagrams of a multi-stage LMBA associated with different test sections of the method of Figure 9 according to an embodiment.
Figures 11A, 11B, and 11C are schematic diagrams of multi-stage LMBAs that each include a power divider to split a combined drive signal according to embodiments.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings. The headings provided herein are for convenience only and do not necessarily affect the scope or meaning of the claims.

Aspects of this disclosure relate to a multi-stage pseudo-Doherty load modulated balanced amplifier (PD-LMBA) architecture with individual input drive signals provided to component amplifiers and an accompanying method that can determine the input drive signals for efficient wideband operation. The extension of a PD-LMBA from two to more stages allows increased efficiency at larger power back-offs. The complexity in drive signal optimization of both two and multi-stage PD-LMBA can be addressed by the accompanying method and a digital splitter.

The LMBA architecture offers potential for high efficiency operation over relatively wide bandwidths. This can be achieved by using a pair of power amplifiers (PAs), including a balanced PA and a control PA. The overall efficiency and output power of the LMBA PA can be dependent on the two component amplifiers' output power and relative phases as they enter an output coupler. The PD-LMBA extends this concept by biasing the balanced PA in Class C, which allows the smaller control PA to efficiently transmit lower power signals, then to act as a load modulator to increase performance and/or optimize the balanced PA for higher output powers. The two stage LMBA architecture can provide high efficiency operation from peak to a back-off of around 8 to 10 decibels (dB).

Performance of the PD-LMBA can significantly degrade if the drive signals to the two PAs are sub-optimal. Some approaches use the average drain current and output power measurements to set the relative phase and the power relationships between the two signals driving the balanced PA and the control PA. This can either be through a radio frequency (RF) splitter or from two separate RF drive signals. In certain implementations of a two stage PD-LMBA, the relationships between the two drive signals can be fixed, with limited variation over frequencies. This can limit performance over bandwidth and create undesirable spectral emissions. This static driving method may not be able to maximize both the efficiency of output power of the PA, where the balanced PA can have its load optimized for maximum power instead of maximum efficiency as the PA approaches saturation.

The extension of the architecture from two to multi-stage PD-LMBA allows a high efficiency range to be extended further. This can involve more complex drive signal specifications to operate efficiently. Existing drive signal optimization techniques may struggle to fully optimize single stage PD-LMBA and may not work at all if applied to multi-stage PD-LMBA systems. Architectural extensions of this disclosure include a current sensor, such as a current sensor on each drain supply placed close to a power amplifier transistor. This together with an observation receiver on the PA output allows the estimation of the wideband efficiency, which can reduce or eliminate technical challenges associated with using average current measurements. A drive signal extraction method provides a process that integrates the wideband efficiency estimates with test signals fed into the PAs. This can generate a frequency selective non-linear digital splitter that can drive the LMBA PA at close to its maximum efficiency. The method can be applicable to both two and multi-stage PD-LMBA systems having three or more stages.

Embodiments of this disclosure address various technical challenges. For example, the multi-drive LMBA architecture allows relatively easy adaption and optimization of the system over a wide bandwidth, without additional RF circuitry. As another example, the independent drive of a control PA can enable a reduction in saturation effects and the ability to modulate the balanced PA's load to increase and/or maximize power output. As one more example, by utilizing a training method, desirable and/or ideal drive signals can be identified during operation, allowing the PA to be retuned if performance characteristics change.

Embodiments of this disclosure relate to: (1) multi-stage PD-LMBAs, (2) current sensors allowing wideband efficiency estimation of LMBA systems, (3) a frequency selective non-linear digital splitter for LMBA drive-signal creation, and (4) methods for drive signal extraction. These features can unify some or all of the architectural elements of LMBA architectures disclosed herein.

A multi-drive PD-LMBA PA can have a separate drive signal for each component amplifier, including the control PA and each balanced PA.

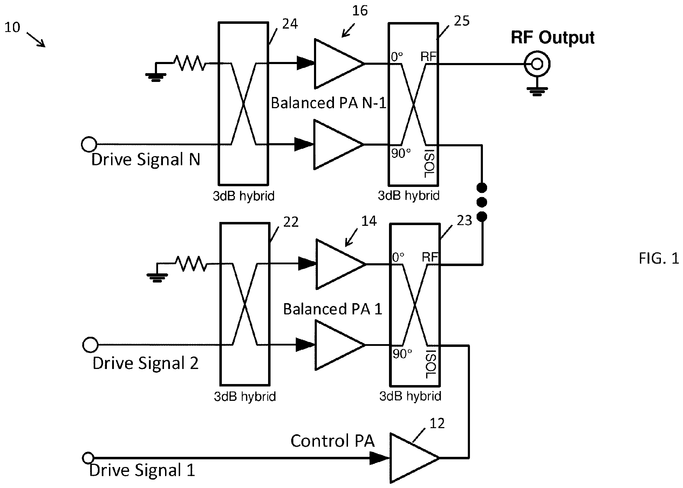

Figure 1 is a schematic diagram of a multi-stage PD-LMBA 10 according to an embodiment. The PD-LMBA 10 extends the PD-LMBA architecture to multiple stages. In the pseudo-Doherty LMBA 10, separate drive signals are provided to each component amplifier. As illustrated in Figure 1, the PD-LMBA 10 includes a control amplifier 12, a first balanced amplifier 14, and an N-1 balanced amplifier 16. In the PD-LMBA 10, the N-1 balanced amplifier 16 is an output balanced amplifier. Each of the amplifiers 12, 14, and 16 can be power amplifiers (PAs). The Pas can include any suitable power amplifier transistors, such as, but not limited to, field effect transistors (e.g., metal oxide semiconductor field effect transistors (MOSFETs), p-type field effect transistors (PFETs), n-type field effect transistors (NFETs), or pseudomorphic high electron mobility transistors (pHEMPTs)) or bipolar transistors. All balanced amplifiers, including the balanced amplifiers 14 and 16, can be in class C bias. This can provide pseudo-Doherty operation, which can allow efficient transmission of lower power signals. Any suitable bias circuit can bias a balanced amplifier, such as balanced amplifiers 14 and 16, in class C. Each additional balanced stage can improve back off efficiency by around 6 dB to 10dB.

Any suitable number of balanced stages can be included in the PD- LMBA 10. Stages of the PD-LMBA are connected in order of output power. The stage with the smallest output power can act as an initial control amplifier. Each subsequent balanced stage can act as a control stage for the next balanced stage, where the balanced stage acting as a control stage has a lower output power than the next balanced stage.

In the PD-LMBA 10, the first balanced amplifier 14 is coupled between a first input coupler 22 and a first output coupler 23. The first input coupler 22 can split a drive signal for the first balanced stage Balanced 1 Drive Signal into two signals that are 90° out of phase with each other for the first balanced amplifier 14 to amplify. The first input coupler 22 can be a 3 decibel (dB) hybrid coupler that is a directional coupler with an equal power split. The first output coupler 23 can combine output signals of the first balanced amplifier 14 and provide the combined output signal to an RF port. The first output coupler 23 can be a 3 dB hybrid coupler. The first output coupler 23 can combine the output signals from the balanced amplifier and bring them in phase with each other. At the same time, the first output coupler can maintain high isolation between the ports. An isolation port of the first output coupler 23 is connected to an output of the control amplifier 12 in the PD-LMBA 10. The RF port of the first output coupler 23 is connected to an isolation port of an output coupler for the next balanced stage of the PD-LMBA 10.

The output balanced amplifier 16 is coupled between an (N-1)th input coupler 24 and an (N-1)th output coupler 25 in the PD-LMBA 10. The (N-1)th input coupler 24 and the (N-1)th output coupler 25 are the last stage input coupler and output coupler, respectively, the PD-LMBA 10. The (N-1)th input coupler 24 can split a drive signal for the output balanced stage Drive Signal N into two signals that are 90° out of phase with each other for the output balanced amplifier 16 to amplify. Each of the input couplers of the PD-LMBA 10 can be a 3dB hybrid coupler and/or implemented any suitable principles and advantages discussed with reference to the first input coupler 22. The (N-1)th output coupler 25 can combine outputs of the output balanced amplifier 16 and provide the combined output signal to an RF port as an RF output signal of the PD-LMBA 10. Each of the output couplers of the PD-LMBA 10 can be a 3dB hybrid coupler and/or implemented any suitable principles and advantages discussed with reference to the first output coupler 23. An isolation port of the (N-1)th output coupler 25 is connected to an output of the preceding balanced stage in the pseudo-Doherty LMBA 10.

To operate at high efficiency, the balanced amplifiers 14 and 16 can be biased in class C. This can allow an output signal from the control amplifier 12 being fed into the isolation port of the first output coupler 23 to experience relatively small and/or minimal attenuation when the first balanced amplifier 14 is not being driven. If this condition is not met, then the efficiency can be significantly impacted. Extending a two stage PD-LMBA so that its output acts as the control signal for a larger balanced stage can allow for greater output powers as well as efficiency at much larger back-offs.

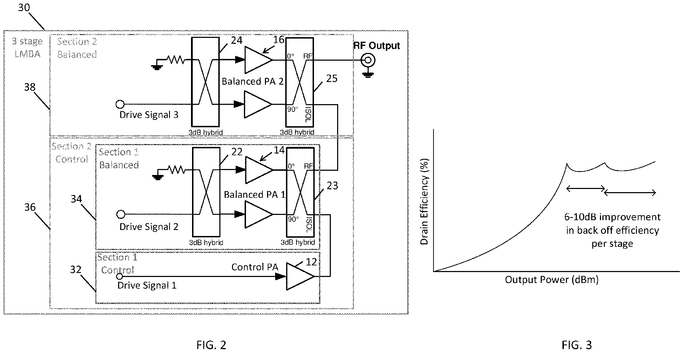

The architecture for a three stage LMBA and a graph indicating increased efficiency at back-off are shown in Figures 2 and 3, respectively. A two stage PD-LMBA can expect to be highly efficient to around 8 dB to 10dB of back-off, while the three stage PD-LMBA can expect to increase this to around 16 dB to 20dB. There can be an attenuation penalty for each stage, related to the number of couplers that the lower power signals traverse. However, this can be offset by the higher efficiency at much higher back-off.

Figure 2 is a schematic diagram of a three stage LMBA 30 according to an embodiment. The three stage LMBA 30 is an example of the PD-LMBA 10 with three stages. The three stages of the LMBA 30 include a control stage 32, a first balanced stage 34, and a second balanced stage 38. As shown in Figure 2, the control stage 32 includes the control amplifier 12. The first balanced stage 34 includes the first balanced amplifier 14, the first input coupler 22, and the first output coupler 23. The output signal from the first control stage 32 drives an isolation port of the first output coupler 23 of the first balanced stage 34. A second control stage 36 includes the first control stage 32 and the first balanced stage 34. A second balanced stage 38 includes the output balanced amplifier 16, a second input coupler 24, and a second output coupler 25. The output signal from the second control stage 36 drives an isolation port of the second output coupler 25 of the second balanced stage 38. Second balanced stage 38 provides an RF output signal of the three stage LMBA 30.

In the three stage LMBA 30, the control amplifier 12 has the lowest output power, the second balanced amplifier 16 has the highest output power, and the first balanced amplifier 14 has an output power between the output power of the control amplifier 12 and the second balanced amplifier 16. The control amplifier 12 is biased in Class-AB while the balanced amplifiers 14 and 16 are biased in class C in the LMBA 30. The amplifiers 12, 14, and 16 can be PAs. In certain applications, the amplifiers 12, 14, and 16 can include field effect transistors (FETs).

Figure 3 is a graph of drain efficiency versus output power for the three stage LMBA 30 of Figure 2 where component amplifiers include FETs. A 6 dB to 10 dB improvement drain efficiency in back off per stage is indicated by Figure 3.

An obstacle to the generalization of a PD-LMBA to a multi-stage architecture has been the complexities in driving PAs in an efficient state. This disclosure provides a robust method for extracting efficient drive signals for a multi-drive architecture including a two stage PD-LMBA. The architectures disclosed herein enable a robust method that can identify efficient wideband drive signals, and then create them using a digital splitter.

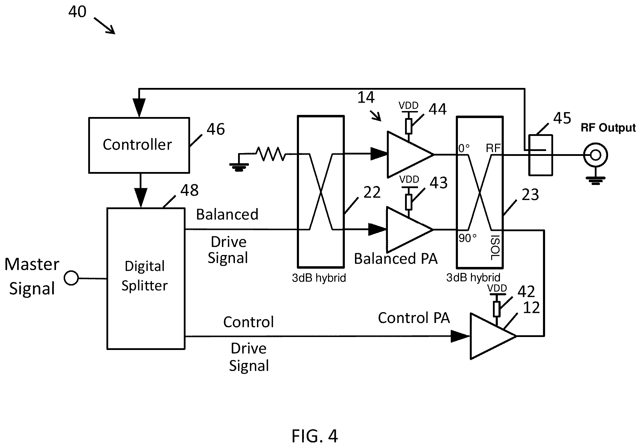

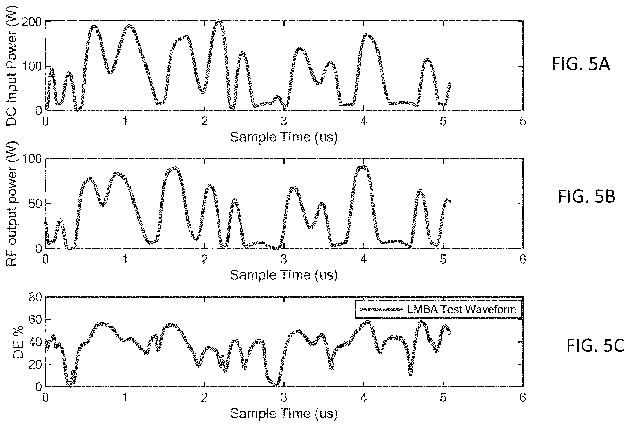

To improve the extraction of wideband performance, current sensors can be included for wideband current sensing. These current sensors can each take the form of a current sense resistor in certain applications. Current sensors can be implemented in accordance with any suitable principles and advantages disclosed herein, such as in multi-stage PD-LMBAs. Example current sensors are shown in Figure 4. Such current sense resistors allow a direct monitoring of current flowing into each power amplifier. When coupled with an observation receiver, which monitors the output of the PA, the current sense resistors can be used to estimate an instantaneous efficiency of the PA for a certain input signal configuration. Example graphs associated with estimating the efficiency from the current sensors and observed RF output power are included in Figures 5A, 5B, and 5C.

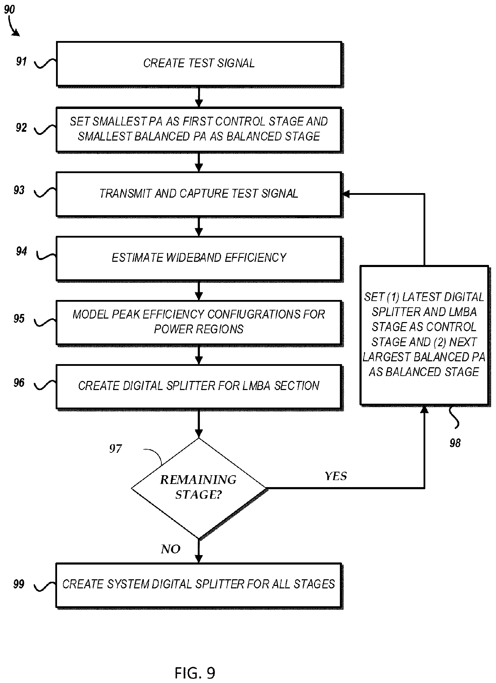

Figure 4 is a schematic diagram of a two stage LMBA circuit 40 with current sensors 42, 43, and 44 according to an embodiment. The current sensors 42, 43, and 44 can be sense resistors. A voltage drop across a sense resistor can be used to sense current. The sense resistor can have a relatively small resistance. The current sensors 42, 43, and 44 can be included close to a drain of a power amplifier transistor of each component amplifier. Such current sense resistors can allow a direct monitoring of current flowing into each power amplifier. Power amplifiers that include field effect transistors can have current sense resistors connected to drains, while power amplifiers that include bipolar transistors can include current sense resistors can be connected to collectors. The current sensors 42, 43, and 44 can provide wideband current sensing. The current sensors 42, 43, and 44 can have higher bandwidth performance than a moving average current measurement. With the current sensors 42, 43, and 44, drive signal extraction methods, such as the method discussed with reference to Figure 9, can be executed faster. Any other suitable current sensors can alternatively or additionally be implemented. Such current sensors can be wideband current sensors.

As illustrated in Figure 4, the LMBA circuit 40 includes a radio frequency coupler 45, a controller 46, and a digital splitter 48. The radio frequency coupler 45 can couple a portion of the RF power generated by the LMBA of the LMBA circuit 40 to an observation receive path. When coupled with an observation receiver, which monitors the radio frequency output signal generated by the LMBA, the current sensor 42, 43, and 44 (e.g., current sense resistors) can be used to estimate an instantaneous efficiency of the LMBA for a certain input signal configuration.

The controller 46 can receive outputs from the current sensors 42, 43, and 44 and an observation receive signal from the RF coupler 45. The controller 46 can estimate direct current (DC) input power from the outputs of the current sensors 42, 43, and 44. The controller 46 can estimate an efficiency of the LMBA of the LMBA circuit 40 based on the observed RF output signal of the LMBA and the estimated wideband DC input power. The controller 46 can estimate output power and efficiency for each input configuration. Each input configuration includes a balance PA drive power, a control PA drive power, and the relative phase between the two PAs drive signals. The controller 46 can be an adaptive controller.

The controller 46 can configure the digital splitter 48 based on the estimate of efficiency of the LMBA. This can involve setting the digital splitter 48 and/or updating the digital splitter 48. The controller 46 can apply a method, such as the method of Figure 9 to determine how to configure the digital splitter 48. The digital splitter 48 can split an input signal Master Signal into drive signals Control Drive Signal and Balanced Drive Signal for stages of the LMBA. The digital splitter 48 can produce an efficient output of the LMBA circuit 40. The digital splitter 48 can be frequency selective and non-linear.

Figures 5A, 5B, and 5C are graphs associate with estimating efficiency of the LMBA of Figure 4. Figure 5A shows the DC input power over time. The DC input power can be determined by the controller 46 of Figure 4 based on outputs of the current sensors 42, 43, and 44. Figure 5B shows the RF output power over time. The controller 46 can determine the RF output power based on an output of the RF coupler 45 that is representative of the RF output power of the LMBA. Figure 5C is graph of efficiency over time for a test LMBA waveform. The efficiency can be determined by the controller 46 based on the DC input power and the RF output power. Efficiency can be RF output power divided by DC input power. In certain instances, there can be a relative delay between measurements of RF output power and DC input power and the controller 46 can account for such a relative delay.

Part of an LMBA circuit can be implemented by a transceiver and part of the LMBA circuit can be implemented by an RF front end. The RF front end can include an LMBA and an RF coupler. The transceiver can include a controller and digital splitter.

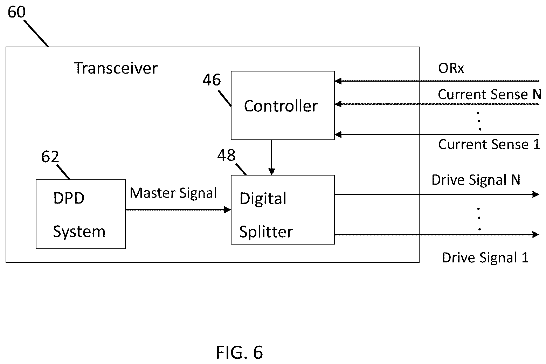

Figure 6 is a schematic block diagram of a transceiver 60 with a controller 46 and a digital splitter 48 according to an embodiment. As illustrated, the transceiver 60 can also include a digital predistortion (DPD) system 62. The transceiver 60 can be implemented on an integrated circuit. The transceiver 60 can provide drive signals for an LMBA.

The transceiver 60 can receive an observation receive signal Orx from an RF front end. The observation receive signal Orx can be generated by an observation receiver that receives an output of an RF coupler that is indicative of RF power of an LMBA. The observation receiver can perform any suitable processing on the output signal from the RF coupler, such as one or more of signal amplification, filtering, down conversion, or the like. The observation receive signal ORx can be provided to the controller 46.

The transceiver 60 can receive current sense signals Current Sense 1 to Current Sense N from current sensors of component amplifiers of the LMBA, such as a control amplifier and one or more balanced amplifiers.

The controller 46 can estimate efficiency of the LMBA based on the observation receive signal Orx and the current sense signals Current Sense 1 to Current Sense N. The controller 46 can perform the method of Figure 9 and/or one or more other drive signal extraction methods. The controller 46 can configure the digital splitter 48 for providing drive signals Drive Signal 1 to Drive Signal N to the LMBA. The digital splitter 48 can split an input signal Master Signal into the drive signals Drive Signal 1 to Drive Signal N for component amplifiers of the LMBA. The input signal Master Signal can be an output signal from the DPD system 62. Accordingly, the input signal Master Signal can be a digitally predistorted signal.

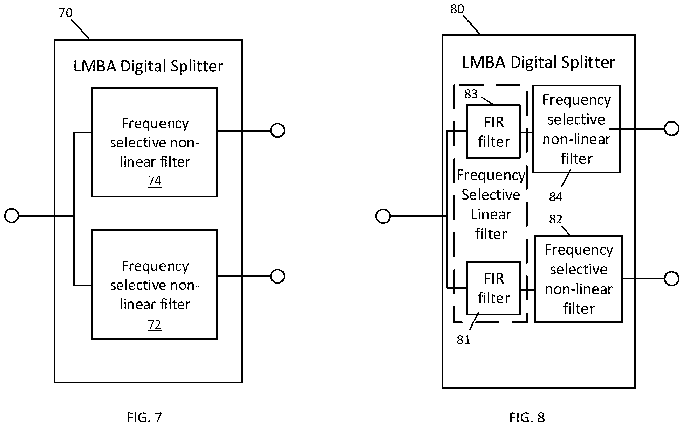

A method of drive signal extraction processes test signal inputs and their corresponding drain current and output powers to estimate the most efficient drive signals. The estimates of most efficient drive signals can then be used to create a frequency selective non-linear drive signal function for a digital splitter. The digital splitter can generate drive signals that result in efficient transmission of a desired input signal. The function of a digital splitter can be to produce an efficient output of the LMBA. An input signal to the digital splitter can be split unevenly to outputs of the digital splitter. The digital splitter can be frequency selective and non-linear. The digital splitter can be frequency dependent. Relative phases of the output signals generated by the digital splitter can change over frequency. The digital splitter functions may be implemented in a single processing step, for example, as shown in Figure 7. The digital splitter functions may be split into several concatenated processing steps, for example, as shown in Figure 8. The several processing steps can include using a finite impulse response (FIR) filter, which can generate linear frequency-dependent elements, coupled with a simpler frequency dependent non-linear stage. An example drive signal extraction method will be discussed with reference to Figure 9.

Figure 7 is a schematic block diagram of a single stage digital splitter 70 according to an embodiment. In the digital splitter 70, frequency selective non-linear functions of the digital splitter are performed in a single processing stage. The digital splitter 70 includes a first frequency selective non-linear filter 72 and a second frequency selective non-linear filter 74. The frequency selective non-linear filters 72 and 74 can include any suitable circuitry, such as processing circuitry implementing Volterra functions and/or look up tables (LUTs). The digital splitter 70 can implement the digital splitter 48 of Figure 4 or Figure 6, for example. While the digital splitter 70 is illustrated and discussed with reference to generating two drive signals, any suitable principles and advantages of the digital splitter 70 can be applied to generating three or more drive signals.

The first frequency selective non-linear filter 72 can provide a first drive signal to a control amplifier, such as the control amplifier 12 of Figure 4. The second frequency selective non-linear filter 74 can provide a second drive signal a balanced amplifier, such as the balanced amplifier 14 of Figure 4. The digital splitter 70 can include additional frequency selective non-linear filters for additional balanced amplifiers of a multi-stage LMBA. Frequency content of an input waveform can be estimated using functions such as instantaneous frequency.

Figure 8 is a schematic block diagram of a multi-stage digital splitter 80 according to an embodiment. The digital splitter 80 can implement the digital splitter 48 of Figure 4 or Figure 6, for example. While the digital splitter 80 is illustrated and discussed with reference to generating two drive signals, any suitable principles and advantages of the digital splitter 80 can be applied to generating three or more drive signals. In the digital splitter 80, functions are split between multiple consecutive stages. As illustrated, each path between an input node and a respective output node includes a frequency selective linear filter and a frequency selective non-linear filter. In the digital splitter 80, a frequency selective liner filter is cascaded with a frequency selective non-linear filter between an input node and an output node.

The digital splitter 80 includes a first frequency selective linear filter 81 and a first frequency selective non-linear filter 82 coupled between the input node and a first output node. The digital splitter 80 also includes a second frequency selective linear filter 83 and a second frequency selective non-linear filter 84 coupled between the input node and a second output node. The frequency selective linear filters 81 and 83 can include any suitable circuitry, such as finite impulse response (FIR) filters. With frequency selective linear filters 81 and 83, the frequency selective non-linear filters 82 and 84 can be simplified relative to the frequency selective non-linear filters 72 and 74 of Figure 7. The frequency selective non-linear filters 82 and 84 can include any suitable circuitry, such as processing circuitry implementing Volterra functions and/or LUTs. In some other applications, three or more processing stages can be included in a path between an input node of a digital splitter and an output node of a digital splitter.

The first frequency selective non-linear filter 82 can provide a first drive signal to a control amplifier, such as the control amplifier 12 of Figure 4. The second frequency selective non-linear filter 84 can provide a second drive signal to a balanced amplifier, such as the balanced amplifier 14 of Figure 4. The digital splitter 80 can include additional frequency selective linear and non-linear filters for additional balanced amplifiers of a multi-stage LMBA. Frequency content of an input waveform can be estimated using functions such as instantaneous frequency.

Any suitable principles and advantages of the digital splitter 70 and the digital splitter 80 can be implemented together with each other. For example, a digital splitter can include one path between an input node and an output node with a single processing stage and another path between the input node and another output node with multiple processing stages.

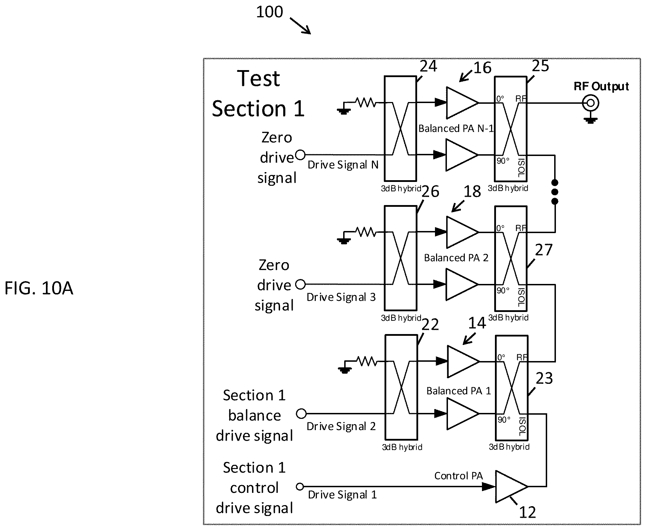

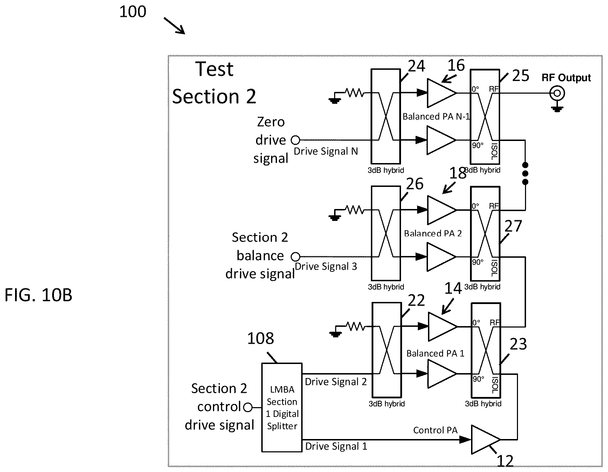

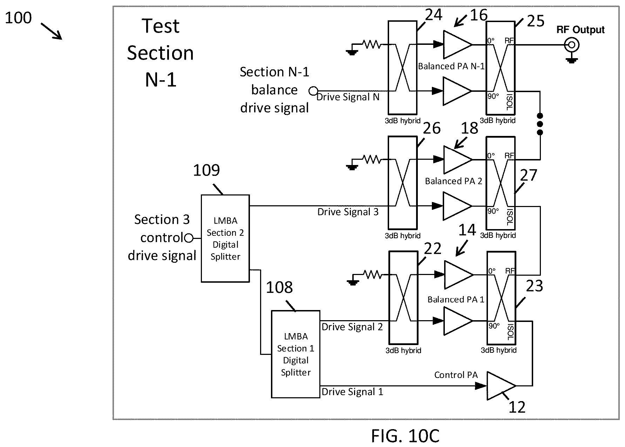

Figure 9 is a flow diagram of a method 90 for drive signal extraction for a multi-stage LMBA according to an embodiment. The method 90 can be run on the adaptive controller, such as the controller 46 of Figure 4 or Figure 6. The method 90 can generate a digital splitter from the test signal data. The method 90 can also adaptively update the digital splitter as more data is transmitted. The method 90 can be run in the field. The method 90 can alternatively or additionally be run in a factory. The method 90 will be discussed with reference to Figures 10A, 10B, and 10C. Figures 10A, 10B, and 10C are schematic diagrams of a multi-stage LMBA 100 associated with different test sections of the method 90 of Figure 9 according to an embodiment.

For a multi-stage PD-LMBA system, the method 90 can be run in stages. The method 90 can first be run on the smallest control amplifier and balanced amplifier, which form the first PD-LMBA section. During this time, the remaining amplifiers may not be driven with any signal. Once the first section is tuned, the first section can act as the control amplifier for the second balanced stage and the first-section can be treated as the smaller control stage of the first iteration. The method 90 can proceed until all stages have been included. A multi-stage PD-LMBA with N-1 balanced stages and 1 control PA stage is shown in Figure 10A, 10B, and 10C, demonstrating the subdivision of each test iteration into a balanced and control stage.

At block 91 of the method 90, a test signal is created. The test signal can stimulate a large number or all permutations of the control stage and the balanced stage input power and relative phases. The test signals can be a pair of waveforms that can test a relatively large number or every permutation of balanced and control input power and relative phases, as these signals can activate a large number or all possible drive signal combinations to the LMBA. To include frequency dependency into these tests, a limited bandwidth test signal can be shifted in center frequency to discreetly test the frequency range of interest. The bandwidth of the test signal can be designed to be no larger than the bandwidth of current sensors of the LMBA.

In the method 90, each LMBA stage is tested in order of power, starting with the smallest. Each LMBA section is divided into a balanced stage and a control stage. The larger stages are not driven. The control amplifier 12 is set as the control stage and smallest balanced amplifier 14 is set as a first balanced stage at block 92. Figure 10A illustrates test section 1 corresponding to block 92. As shown in Figure 10A, zero drive signals are provided to balanced amplifiers 16 and 18. Accordingly, the larger balanced stages are not driven for test section 1.

The method 90 performs processing for each test section. Processing for each test section can include processing at blocks 93 to 96 of the method 90. A test signal is transmitted and captured at block 93. For instance, in test section 1, a test signal can be transmitted to the control amplifier 12 and the balanced amplifier 14. The test signal can include individual drive signals for the control amplifier 12 and the balanced amplifier 14 in this example. The resulting drain currents and RF waveform can be captured for amplifiers that include field effect transistors. As discussed above, the test signal can stimulate a large number of permutations of the control stage and the balanced stage input power and relative phases.

The wideband efficiency of the test signal is estimated at block 94. Accordingly, a measure of efficiency of the LMBA for a test signal can be determined. This can involve using the output power and drain current measurements to calculate the instantaneous efficiency of the output signal for each input configuration. Configurations that result in peak or near peak efficiency for a given output power are stored in memory and modeled at block 95. These configurations can be for a given output power.

The output power range can be modeled for a plurality of regions, for example three regions, at block 95. The plurality of regions can be power regions. As an example, the plurality of power regions can include a low power region, a medium power region, and a high power region. Accordingly, the modeling can divide the drive stages into three regions corresponding to low, medium, and high output power.

In the low power region, power can be delivered from the control stage (e.g., the control amplifier 12 for test section 1) and the balanced stage (e.g., the balanced amplifier 14 for test section 1) can be off. The low region is when the control stage provides all the power, with the balanced stage not being fed. In the middle power region, the control stage can be close to saturation, relative phase can be static and optimize balanced stage PA output. The balanced stage can modulate output power in the middle power range. In the high power stage, the control stage can be used to modulate the balanced stage output from peak efficiency, to peak output power. Both the balanced stage and the control stage can change power and phase in the high power range. This can maximize output power of the LMBA in the high power region.

Once drive regions have been modeled over the frequency of interest, a digital splitter can be formed for an LMBA stage. A digital splitter for the LMBA section can be created at block 96. This can involve jointly processing estimates/measures of efficiency for different power ranges. Frequency dependence can be implemented in structures, such as filters and/or lookup tables (LUTs), using functions, such as instantaneous frequency, to determine the frequency components of the signal. The digital splitter for an LMBA section can create an input signal for the control stage and the balanced stage of the LMBA section. The digital splitter for an LMBA section can then be utilized as a control stage for the next test iteration.

For a single section LMBA system, blocks 93-96 of the method 90 can be performed one time. For a multi-stage LMBA system, the processing at blocks 93-96 can be repeated, with the control signal fed into the digital splitter just created, the next balanced amplifier being used as the balance stage, and any remaining larger balanced stages remaining undriven. This can then create another digital splitter that can in turn be used as the control stage for the next LMBA stage. Once all stages have been characterized, the final digital spitter can either be formed from a combination of the individual digital splitters or remain as several discrete processing blocks.

Referring to Figure 9, the method 90 can determine whether there are remaining test sections at block 97. In response to determining that there is at least one remining stage, the control stage and the balanced stage can be set for the next test section at block 98. The control stage can be the latest digital splitter and previous test section, and the balanced stage can be the next largest balanced stage of the LMBA.

Figure 10B illustrates the LMBA 100 configured for test section 2 as set by block 98. In test section 2, the control stage includes the control amplifier 12, the balanced amplifier 14, associated input couplers and output couplers, and digital splitter 108. The digital splitter 108 can be configured based on test section 1. The digital splitter 108 can be a portion of the digital splitter 48 of Figure 6, for example. In test section 2, the balanced stage can include the balanced amplifier 18. The balanced stage for test section 2 can also include an input coupler 26 and an output coupler 27. As shown in Figure 10B, a zero drive signal is provided to the remaining balanced amplifiers, including the output balanced amplifier 16. Accordingly, the larger balanced stages are not driven for test section 2. The method 90 can proceed through blocks 93 to 96 to create a digital splitter for the second LMBA section.

Figure 10C illustrates the LMBA 100 configured for test section N-1 as set by block 98. In test section N-1, the control stage includes the control amplifier 12, the balanced amplifiers 14 and 18, associated input couplers and output couplers, and digital splitters 108 and 109, as well as any remaining balanced amplifiers and associated digital splitters where N>3. The digital splitter 109 can be configured based on test section 2. The digital splitter 109 can be a portion of the digital splitter 48 of Figure 6, for example. In test section N-1, the balanced stage can include the output balanced amplifier 16. As shown in Figure 10C, all component amplifiers of the LMBA 100 are separately driven for test section N-1. The method 90 can proceed through blocks 93 to 96 to create a digital splitter for the final LMBA section.

In response to determining that there are no remining stages at block 97, a final digital splitter for the LMBA 100 can be created at block 99. The final digital splitter can be formed either from individual splitters for each LMBA section or by combining the digital splitters from individual LMBA sections into one digital splitter. The final digital splitter can correspond to the digital splitter 48 Figure 6, for example. The final digital splitter can be implemented in accordance with any suitable principles and advantages of one or more of the digital splitter 48 of Figure 4, the digital splitter 48 of Figure 6, the digital splitter 70 of Figure 7, or the digital splitter 80 of Figure 8.

Certain multi-stage PD-LMBAs, such as the multi-stage PD-LMBA 10 of Figure 1, have a separate RF input from a transceiver connected to each component amplifier. To reduce the number of transceiver chains driving a multi-stage LMBA, component amplifiers can be grouped using an RF power divider. The RF power divider can be driven by the transceiver. Combining component amplifiers can be implemented in any suitable multi-stage LMBA with at least two stages. In certain applications, the RF power divider can be unequal and/or frequency selective and/or include a delay line component to optimize the driving of the grouped amplifiers.

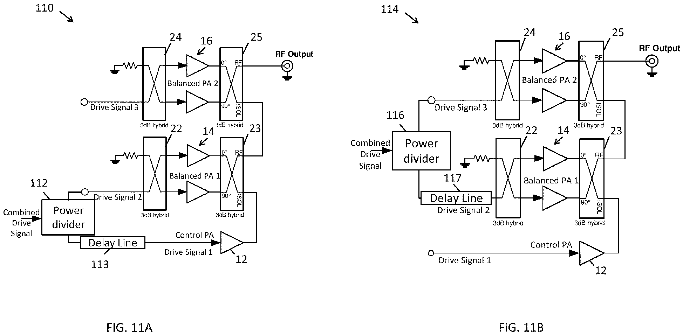

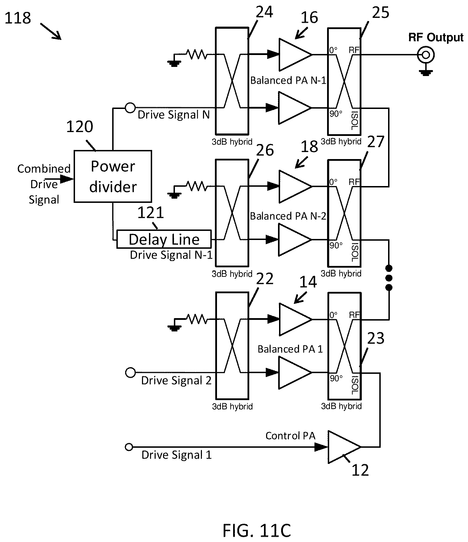

Figures 11A, 11B, and 11C are schematic diagrams of multi-stage LMBAs that each include a power divider to split a combined drive signal according to embodiments. A transceiver that provides drive signals to these multi-stage LMBAs can include one less receiver chain with a power divider.

Figure 11A illustrates a multi-stage LMBA 110 that includes an RF power divider 112. The RF power divider 112 receives a combined drive signal and provides separate drive signals to the control stage and the first balanced stage of the multi-stage LMBA 110. The multi-stage LMBA 110 is similar to using a single input LMBA as a control stage. The multi-stage LMBA 110 is similar to the PD-LMBA 10 of Figure 1, except that the RF power divider 112 provides separate drive signals for the control amplifier 12 and the first balanced amplifier 14 from a combined drive signal. The combined drive signal can be provided by a transceiver. In addition, a delay line 113 can be in a signal path between the RF power divider 112 and the control amplifier 12.

Figure 11B illustrates a multi-stage LMBA 114 that includes an RF power divider 116. The RF power divider 116 receives a combined drive signal and provides separate drive signals to the two balanced stages of the multi-stage LMBA 114. The multi-stage LMBA 114 is similar to the pseudo-Doherty LMBA 10 of Figure 1, except that the RF power divider 116 provides separate drive signals for the balanced amplifiers 14 and 16 from a combined drive signal. The combined drive signal can be provided by a transceiver. In addition, a delay line 117 can be in a signal path between the RF power divider 116 and the input coupler 22.

Figure 11C illustrates a multi-stage LMBA 118 that includes an RF power divider 120. The RF power divider 120 receives a combined drive signal and provides separate drive signals to the final two balanced stages of the multi-stage LMBA 118. The two final balanced stages coupled to the RF power divider 120 are the highest power stages of the multi-stage LMBA 118. In addition, a delay line 121 can be in a signal path between the RF power divider 120 and the input coupler 26.

Pseudo-Doherty LMBAs are disclosed. These LMBAs can include a plurality of power amplifiers, including a control power amplifier and balanced amplifiers, arranged in an LMBA architecture. In an embodiment, an LMBA architecture is provided that includes multiple stages of balanced amplifiers, where a smaller balanced amplifier has an output connected to an output coupler isolation port of a larger balanced amplifier. In an embodiment, an LMBA architecture includes one or more balanced amplifiers and a control amplifier driven by separate drive signals. The one or more balanced amplifiers can be biased in Class C.

According to certain embodiments, LMBA architectures include current sensors and an observation receiver path. Such an LMBA architecture can include a digital splitter to create the LMBA drive signals. An adaptive method can be performed to update the digital splitter. The digital splitter can include non-linear frequency selective processing blocks. Certain digital splitters can include FIR filters to provide a frequency dependent phase shift. The frequency dependent phase shift can be a characteristic of an optimum or near optimum relative phase between the control and balanced PAs. An input signal can pass through a digital predistortion (DPD) system before being fed into digital splitter. The adaptive method can identify efficient drive signal configurations of the LMBA from the response of the observation receiver and current sensors to training signals fed into the drive inputs. The adaptive method can identify multiple drive regions or modes of the LMBA from the response of the observation receiver and current sensors to training signals fed into the drive inputs. The adaptive method can model the drive signals to create efficient outputs. These models can then be used in the digital splitter. An optimization process can increase performance of each stage of a multi-stage LMBA system, where the digital splitters are optimized in order of output power, in each of the LMBA sections.

In the embodiments of this disclosure, circuits, systems and methods are described in connection with particular embodiments. It will be understood, however, that any suitable principles and advantages of the embodiments of this disclosure can be used for any other systems, apparatus, electronic devices, or methods with a need for the technology disclosed herein, such as LMBAs. Moreover, any suitable principles and advantages disclosed herein can be implemented in systems and in methods that include an LMBA and transmit a radio frequency signal via one or more antennas. The elements and acts of the various embodiments of this disclosure can be combined to provide further embodiments. The acts of the methods discussed herein can be performed in any order as appropriate. Moreover, the acts of the methods discussed herein can be performed serially or in parallel, as appropriate.

The principles and advantages described herein can be implemented in various apparatuses. Examples of such apparatuses can include, but are not limited to, communications infrastructure such as wireless communications infrastructure, consumer electronic products, parts of the consumer electronic products, electronic test equipment, vehicular electronics products, industrial electronics products, etc. Electronic products can include, but are not limited to, base stations such as cellular base stations, access points, repeaters, relays, wireless communication devices, a mobile phone (for example, a smart phone), a hand-held computer, a tablet computer, a laptop computer, a wearable computing device, a vehicular electronics system, a radio, a wearable health monitoring device, etc. Further, apparatuses can include unfinished products.

Conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or whether these features, elements and/or states are included or are to be performed in any particular embodiment.

Unless the context clearly requires otherwise, throughout the disclosure and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used in this disclosure, refer to two or more elements that may be either directly connected, or connected by way of one or more intermediate elements. Additionally, the words "herein," "above," "below," and words of similar import, when used in this application, shall refer to this application as a whole and not to any particular portions of this application.

Where the context permits, words in this disclosure using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values provided herein are intended to include similar values within a measurement error.

While certain embodiments have been described, these embodiments have been presented by way of example only, and are not intended to limit the scope of the disclosure. Indeed, the circuits, systems, and methods of this disclosure may be embodied in a variety of other forms. Furthermore, various omissions, substitutions and changes in the form of the methods, circuits, modules, and systems described herein may be made without departing from the spirit of the disclosure. Such changes and modifications are to be understood as being included within the scope of the disclosure. For example, while blocks are presented in a given arrangement, alternative embodiments may perform similar functionalities with different components and/or circuit topologies, and some blocks may be deleted, moved, added, subdivided, combined, and/or modified. Each of these blocks may be implemented in a variety of different ways. Any suitable combination of the elements and acts of the various embodiments described herein can be combined to provide further embodiments. The various features and processes described above may be implemented independently of one another or may be combined in various ways. All possible combinations and sub-combinations of features of this disclosure are intended to fall within the scope of this disclosure.

### Numbered aspects

By way of non-limiting example, some aspects of the disclosure are set out in the following numbered clauses.
Numbered Clause 1. A multi-stage pseudo-Doherty load modulated balanced amplifier circuit comprising:
   a control stage comprising a control amplifier;
   a first balanced stage comprising a first balanced amplifier and a first output coupler, the first balanced amplifier coupled to the first output coupler and configured to be biased in class C, the first output coupler having a port connected to an output of the control amplifier; and
   a second balanced stage comprising a second balanced amplifier and a second output coupler, the second balanced amplifier coupled to the second output coupler and configured to be biased in class C, the second output coupler having a port connected to an output of the first balanced stage.
Numbered Clause 2. The multi-stage pseudo-Doherty load modulated balanced amplifier circuit of Numbered Clause 1, wherein the first balanced stage and the second balanced stage are configured to receive separate drive signals.
Numbered Clause 3. The multi-stage pseudo-Doherty load modulated balanced amplifier circuit of Numbered Clause 2, further comprising a digital splitter configured to provide the separate drive signals.
Numbered Clause 4. The multi-stage pseudo-Doherty load modulated balanced amplifier circuit of Numbered Clause 3, wherein the digital splitter is configured to implement non-linear frequency selective functions.
Numbered Clause 5. The multi-stage pseudo-Doherty load modulated balanced amplifier circuit of Numbered Clause 3 or 4, further comprising a controller configured to update the digital splitter.
Numbered Clause 6. The multi-stage pseudo-Doherty load modulated balanced amplifier circuit of any preceding Numbered Clause, wherein the port of the second output coupler connected to the output of the first balanced stage is an isolation port.
Numbered Clause 7. The multi-stage pseudo-Doherty load modulated balanced amplifier circuit of any preceding Numbered Clause, further comprising a first current sensor and a second current sensor, the first current sensor configured to provide an indication of direct current input power of the first balanced stage, and the second current sensor configured to provide an indication of direct current input power of the second balanced stage.
Numbered Clause 8. The multi-stage pseudo-Doherty load modulated balanced amplifier circuit of Numbered Clause 7, further comprising a radio frequency coupler and a controller, the radio frequency coupler connected to a radio frequency output port of the second output coupler, the radio frequency coupler coupled to the controller, and the controller coupled to the first current sensor and the second current sensor.
Numbered Clause 9. The multi-stage pseudo-Doherty load modulated balanced amplifier circuit of Numbered Clause 8, further comprising a third current sensor coupled to the controller, the third current sensor configured to provide an indication of direct current input power of the control stage.
Numbered Clause 10. The multi-stage pseudo-Doherty load modulated balanced amplifier circuit of any preceding Numbered Clause, further comprising one or more additional balanced stages each comprising an additional balanced amplifier configured to be biased in class C and an additional output coupler, the additional output coupler of each of the one or more additional balanced stages having a port driven by another stage of the multi-stage pseudo-Doherty load modulated balanced amplifier circuit.
Numbered Clause 11. The multi-stage pseudo-Doherty load modulated balanced amplifier circuit of any preceding Numbered Clause, further comprising a radio frequency power divider coupled to two stages of the multi-stage pseudo-Doherty load modulated balanced amplifier circuit, the radio frequency power divider configured to divide power of a combined drive signal to the two stages of the multi-stage pseudo-Doherty load modulated balanced amplifier circuit.
Numbered Clause 12. The multi-stage pseudo-Doherty load modulated balanced amplifier circuit of any preceding Numbered Clause, wherein the multi-stage pseudo-Doherty load modulated balanced amplifier circuit is operable in a plurality of power modes.
Numbered Clause 13. The multi-stage pseudo-Doherty load modulated balanced amplifier circuit of Numbered Clause 12, wherein the plurality of power modes comprise a high power mode where the control amplifier modulates the first balanced amplifier from peak efficiency to peak output power.
Numbered Clause 14. The multi-stage pseudo-Doherty load modulated balanced amplifier circuit of Numbered Clause 12 or 13, wherein the plurality of power modes comprise a high power mode where separate drive signals for the control stage and the first balanced stage change power and phase.
Numbered Clause 15. A method of signal amplification with a multi-stage pseudo-Doherty load modulated balanced amplifier circuit, the method comprising:
   biasing a first balanced amplifier and a second balanced amplifier of the multi-stage pseudo-Doherty load modulated balanced amplifier circuit in class C;
   providing separate drive signals to the first balanced amplifier, the second balanced amplifier, and a control amplifier of the multi-stage pseudo-Doherty load modulated balanced amplifier circuit; and
   providing, by the multi-stage pseudo-Doherty load modulated balanced amplifier circuit, an amplified radio frequency output signal,
   wherein the first balanced amplifier is coupled to a first output coupler that has an isolation port connected to an output of the control amplifier, and the second balanced amplifier is coupled to a second output coupler that has an isolation port connected to a radio frequency output port of the first output coupler.
Numbered Clause 16. The method of Numbered Clause 15, further comprising generating the separate drive signals using a digital splitter.
Numbered Clause 17. The method of Numbered Clause 16, further comprising updating the digital splitter based on outputs of currents sensors associated with the first balanced amplifier, the second balanced amplifier, and the control amplifier.
Numbered Clause 18. The method of Numbered Clause 17, wherein the updating the digital splitter is based on the amplified radio frequency output signal.
Numbered Clause 19. The method of any of Numbered Clauses 15 to 18, wherein the multi-stage load modulated balanced amplifier circuit comprises one or more additional balanced amplifiers.
Numbered Clause 20. A multi-stage pseudo-Doherty load modulated balanced amplifier circuit comprising:
   a control stage comprising a control amplifier;
   a first balanced stage comprising a first balanced amplifier, a first current sensor configured to provide an indication of direct current input power of the first balanced stage, and a first output coupler, the first balanced amplifier coupled to the first output coupler and configured to be biased in class C, the first output coupler having an isolation port connected to an output of the control amplifier; and
   a second balanced stage comprising a second balanced amplifier, a second current sensor configured to provide an indication of direct current input power of the second balanced stage, and a second output coupler, the second balanced amplifier coupled to the second output coupler and configured to be biased in class C, the second output coupler having an isolation port connected to an output of the first balanced stage, the first balanced stage and the second balanced stage configured to receive separate drive signals.

## Claims

1. A multi-stage pseudo-Doherty load modulated balanced amplifier circuit comprising:
a control stage comprising a control amplifier;
a first balanced stage comprising a first balanced amplifier and a first output coupler, the first balanced amplifier coupled to the first output coupler and configured to be biased in class C, the first output coupler having a port connected to an output of the control amplifier; and
a second balanced stage comprising a second balanced amplifier and a second output coupler, the second balanced amplifier coupled to the second output coupler and configured to be biased in class C, the second output coupler having a port connected to an output of the first balanced stage.

2. The multi-stage pseudo-Doherty load modulated balanced amplifier circuit of Claim 1, wherein the first balanced stage and the second balanced stage are configured to receive separate drive signals.

3. The multi-stage pseudo-Doherty load modulated balanced amplifier circuit of Claim 2, further comprising a digital splitter configured to provide the separate drive signals.

4. The multi-stage pseudo-Doherty load modulated balanced amplifier circuit of Claim 3, wherein the digital splitter is configured to implement non-linear frequency selective functions and/or wherein the multi-stage pseudo-Doherty load modulated balanced amplifier further comprises a controller configured to update the digital splitter.

5. The multi-stage pseudo-Doherty load modulated balanced amplifier circuit of any preceding Claim, wherein the port of the second output coupler connected to the output of the first balanced stage is an isolation port.

6. The multi-stage pseudo-Doherty load modulated balanced amplifier circuit of any preceding Claim, further comprising a first current sensor and a second current sensor, the first current sensor configured to provide an indication of direct current input power of the first balanced stage, and the second current sensor configured to provide an indication of direct current input power of the second balanced stage.

7. The multi-stage pseudo-Doherty load modulated balanced amplifier circuit of Claim 6, further comprising a radio frequency coupler and a controller, the radio frequency coupler connected to a radio frequency output port of the second output coupler, the radio frequency coupler coupled to the controller, and the controller coupled to the first current sensor and the second current sensor, preferably further comprising a third current sensor coupled to the controller, the third current sensor configured to provide an indication of direct current input power of the control stage.

8. The multi-stage pseudo-Doherty load modulated balanced amplifier circuit of any preceding Claim, further comprising one or more additional balanced stages each comprising an additional balanced amplifier configured to be biased in class C and an additional output coupler, the additional output coupler of each of the one or more additional balanced stages having a port driven by another stage of the multi-stage pseudo-Doherty load modulated balanced amplifier circuit.

9. The multi-stage pseudo-Doherty load modulated balanced amplifier circuit of any preceding Claim, further comprising a radio frequency power divider coupled to two stages of the multi-stage pseudo-Doherty load modulated balanced amplifier circuit, the radio frequency power divider configured to divide power of a combined drive signal to the two stages of the multi-stage pseudo-Doherty load modulated balanced amplifier circuit.

10. The multi-stage pseudo-Doherty load modulated balanced amplifier circuit of any preceding Claim, wherein the multi-stage pseudo-Doherty load modulated balanced amplifier circuit is operable in a plurality of power modes.

11. The multi-stage pseudo-Doherty load modulated balanced amplifier circuit of Claim 10, wherein the plurality of power modes comprise a high power mode where the control amplifier modulates the first balanced amplifier from peak efficiency to peak output power.

12. The multi-stage pseudo-Doherty load modulated balanced amplifier circuit of Claim 10 or 11, wherein the plurality of power modes comprise a high power mode where separate drive signals for the control stage and the first balanced stage change power and phase.

13. A method of signal amplification with a multi-stage pseudo-Doherty load modulated balanced amplifier circuit, the method comprising:
biasing a first balanced amplifier and a second balanced amplifier of the multi-stage pseudo-Doherty load modulated balanced amplifier circuit in class C;
providing separate drive signals to the first balanced amplifier, the second balanced amplifier, and a control amplifier of the multi-stage pseudo-Doherty load modulated balanced amplifier circuit; and
providing, by the multi-stage pseudo-Doherty load modulated balanced amplifier circuit, an amplified radio frequency output signal,
wherein the first balanced amplifier is coupled to a first output coupler that has an isolation port connected to an output of the control amplifier, and the second balanced amplifier is coupled to a second output coupler that has an isolation port connected to a radio frequency output port of the first output coupler.

14. The method of Claim 13, further comprising generating the separate drive signals using a digital splitter, preferably further comprising updating the digital splitter based on outputs of currents sensors associated with the first balanced amplifier, the second balanced amplifier, and the control amplifier, more preferably wherein the updating the digital splitter is based on the amplified radio frequency output signal.

15. The method of Claim 13 or 14, wherein the multi-stage load modulated balanced amplifier circuit comprises one or more additional balanced amplifiers.
